(19) Europäisches Patentamt
European Patent Office
Office européen des brevets

(11) EP 4 583 186 A1

(12) **EUROPEAN PATENT APPLICATION**
published in accordance with Art. 153(4) EPC

(43) Date of publication:
**09.07.2025 Bulletin 2025/28**

(21) Application number: **23880263.1**

(22) Date of filing: **19.10.2023**

(51) International Patent Classification (IPC):
***H01M 4/131*** *(2010.01)* ***H01M 4/66*** *(2006.01)*
***C08G 61/12*** *(2006.01)* ***C08G 65/326*** *(2006.01)*
***H01M 10/052*** *(2010.01)* ***H01M 4/02*** *(2006.01)*

(52) Cooperative Patent Classification (CPC):
**C08G 61/12; C08G 65/326; H01M 4/02; H01M 4/13; H01M 4/131; H01M 4/62; H01M 4/66; H01M 10/052; H01M 10/42;** Y02E 60/10

(86) International application number:
**PCT/KR2023/016274**

(87) International publication number:
**WO 2024/085688 (25.04.2024 Gazette 2024/17)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **19.10.2022 KR 20220135150**

(71) Applicants:
- **LG CHEM, LTD.**
  **Seoul 07336 (KR)**
- **LG Energy Solution, Ltd.**
  **Seoul 07335 (KR)**

(72) Inventors:
- **CHOI, Hyun Ju**
  **Daejeon 34122 (KR)**
- **KANG, Joon Koo**
  **Daejeon 34122 (KR)**
- **KWON, Soon Ho**
  **Daejeon 34122 (KR)**
- **CHO, Woo Hyung**
  **Daejeon 34122 (KR)**
- **KIM, Min Gyu**
  **Daejeon 34122 (KR)**
- **KIM, Ki Hwan**
  **Daejeon 34122 (KR)**
- **PARK, Eun Kyoung**
  **Daejeon 34122 (KR)**
- **SONG, In Taek**
  **Daejeon 34122 (KR)**
- **KOH, Jong Kwan**
  **Daejeon 34122 (KR)**
- **YANG, Hee Myeong**
  **Daejeon 34122 (KR)**
- **PARK, Sung Bin**
  **Daejeon 34122 (KR)**

(74) Representative: **Plasseraud IP**
**104 Rue de Richelieu**
**CS92104**
**75080 Paris Cedex 02 (FR)**

(54) **ELECTRODE**

(57) The present specification discloses an electrode and a use thereof. The electrode comprises a polymer layer showing a PCT (positive temperature coefficient) effect and an oxidation potential, which are controlled according to objectives. Such an electrode cannot affect or can rather improve, in a normal state, performance and operation of a secondary battery by exhibiting excellent electrical properties such as low resistance, and can ensure, in an abnormal state, stability. The present specification also discloses a use of the electrode.

[Figure 3]

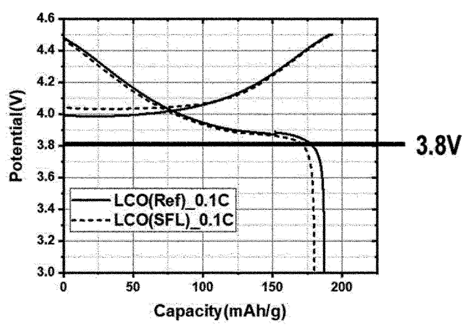


EP 4 583 186 A1

# Description

## Technical Field

This application claims the benefit of priority based on Korean Patent Application No. 10-2022-0135150 dated October 19, 2022, the disclosure of which is incorporated herein by reference in its entirety.

The present specification discloses an electrode and a use thereof.

## Background Art

An energy storage technology has expanded application areas to mobile phones, tablet and notebook PCs, or electric vehicles, and the like.

As the data processing speed of mobile devices such as mobile phones or tablets increases and their usage hours also increase, the development of secondary batteries with high energy density and operating potential, long cycle life, and low self-discharge rate is in progress.

In addition, as major developed countries suppress production of cars driven by internal combustion engines to alleviate global warming and air pollution, major automobile manufacturers also develop various electric vehicles, and thus the importance of secondary batteries having high energy density, high discharge voltage, and output stability increases as driving sources thereof.

However, according to the above trend, the occurrence frequency of ignition or explosion accidents due to overcharging, high-temperature exposure or outer shocks, and the like in devices or automobiles using secondary batteries as an energy source also increases.

As a main cause of such accidents, a short phenomenon, in which a positive electrode and a negative electrode inside an electrode assembly come into direct contact with each other mainly due to external stimuli, is known. When the secondary battery is overcharged or exposed to high temperatures or external stimuli, the short phenomenon can occur by the separator shrinkage due to the internal temperature increase of the secondary battery, or the internal structure destruction of the secondary battery due to outer shocks, and the like.

When the short phenomenon occurs, migration of lithium ions and electrons is concentrated through the region where the positive electrode and the negative electrode are in direct contact with each other, so that internal heat generation can be promoted. Accordingly, it is known that as gas or the like is generated inside the battery, the volume expands, and the risk of ignition increases.

## Disclosure

## Technical Problem

The present specification discloses an electrode and a use thereof. The present specification is intended to disclose an electrode comprising a polymer layer exhibiting a PTC (positive temperature coefficient) effect and an oxidation potential, which are controlled according to objectives. Such an electrode cannot affect or can rather improve, in a normal state, performance and operation of a secondary battery by exhibiting excellent electrical properties such as low resistance, and can ensure, in an abnormal state, stability. The present specification is also intended to disclose a use of the electrode.

## Technical Solution

In this specification, the term room temperature means a natural temperature without heating or cooling, which may be, for example, any one temperature in a range of 10°C to 30°C, or a temperature of about 23°C, or about 25°C or so.

Among the physical properties mentioned in this specification, when the measurement temperature affects the physical property, the relevant physical property is a physical property measured at room temperature, unless otherwise specified.

The unit of temperature in this specification is Celsius (°C), unless otherwise specified.

In this specification, the term normal pressure means a natural pressure without pressurization or depressurization, which may usually mean a pressure of about 730 mmHg to 790 mmHg or so. Among the physical properties mentioned in this specification, when the measurement pressure affects the physical property, the relevant physical property is a physical property measured at normal pressure, unless otherwise specified.

Among the physical properties mentioned in this specification, when the measurement humidity affects the result, the relevant physical property is a physical property measured at humidity under standard conditions, unless otherwise specified.

The humidity under standard conditions means any relative humidity in a range of 40% to 60% in relative humidity, which means, for example, relative humidity of 55%, or 60% or so.

In this specification, the term normal state means a normal operating state of a secondary battery (e.g., a normal charging or discharging state of a secondary battery), or a storage state thereof.

In this specification, the term abnormal state means a dangerous state in which abnormal charge flow, abnormal heating, or explosion, and the like occurs due to an external impact and/or a short circuit phenomenon, and the like, or in which a probability of occurrence of such an abnormal state is increased.

The present specification discloses an electrode.

The electrode may comprise a current collector, an active material layer formed on the current collector, and a polymer layer formed between the current collector and the active material layer. Figure 1 is a cross-sectional diagram of an exemplary electrode sequentially comprising the current collector (100), the polymer layer (200), and the active material layer (300). As in the drawing, the current collector (100), the polymer layer (200), and the active material layer (300) may be in contact with each other. If necessary, other elements may exist between the current collector (100) and the polymer layer (200) and/or between the polymer layer (200) and the active material layer (300). In addition, although the drawing shows a case in which the active material layer (300) exists only on one side of the current collector (100), the active material layer (300) may also exist on both sides of the current collector (100). In this case, the polymer layer (200) may also exist in two layers between each of the active material layers (300) present on both sides of the current collector (100) and the current collector (100), and may also exist in one layer between any one of the active material layers (300) present on both sides and the current collector (100).

The electrode may be, for example, a positive electrode (anode) or a negative electrode (cathode) applied to a secondary battery.

The polymer layer included in the electrode is a layer including a polymer. Such a polymer may be a conductive polymer to be described below.

In the electrode, the polymer layer is provided to exhibit a controlled PTC (Positive Temperature Coefficient) effect. As is known, the PTC effect is an effect in which resistance increases depending on the temperature. The polymer layer is provided so that the PTC effect appears at the temperature of the abnormal state. Therefore, the electrode may exhibit stable performance due to the excellent electrical characteristics of the polymer layer in the normal state, and stability may be secured through the increase in resistance of the polymer layer in the abnormal state.

In the electrode, the polymer layer may exhibit an oxidation potential adjusted in relation to the active material layer.

For example, the polymer layer or the conductive polymer included therein in the electrode may have a lower oxidation potential than the electrode active material or the active material layer. Through this adjustment, stable performance may be maintained even when repeated charging and discharging is performed, or high-speed charging and/or high-speed discharging is performed for a secondary battery to which the electrode is applied.

Here, the oxidation potential of the conductive polymer or polymer layer is an oxidation potential relative to lithium, which is an oxidation potential for lithium and lithium ions (based on $Li/Li^+$), and can be measured in the manner described in "4. Oxidation potential measurement method (conductive polymer/polymer layer)" of Example sections in this specification.

Here, the oxidation potential of the electrode active material or active material layer is an oxidation potential relative to lithium, which is an oxidation potential for lithium and lithium ions (based on $Li/Li^+$), and can be measured in the manner described in "5. Oxidation potential measurement method (electrode active material)" of Example sections in this specification.

For example, the electrode may be designed so that RV of Equation 1 below is within a predetermined range.

[Equation 1]

$$RV = 100 \times Va/Vs$$

In Equation 1, Va is the oxidation potential of the electrode active material or active material layer, and Vs is the oxidation potential of the conductive polymer or polymer layer.

The lower limit of RV in Equation 1 may be 100, 100.5, 101, 101.5, 102, or 102.5 or so, and the upper limit thereof may be 200, 195, 190, 185, 180, 175, 170, 165, 160, 155, 150, 145, 140, 135, 130, 125, 120, 115, 110, 109, 108, 107, 106, 105, 104, or 103 or so. The RV may be within a range of more than or equal to, or more than any one of the above-described lower limits; or may also have a range between less than or equal to, or less than any one of the above-described upper limits and more than or equal to, or more than any one of the above-described lower limits.

In Equation 1 above, the oxidation potential Va is determined according to the type of electrode active material, which is not particularly limited. For example, the lower limit of the oxidation potential Va may be 2.0V, 2.1V, 2.2V, 2.3V, 2.4V, 2.5V, 2.6V, 2.7V, 2.8V, 2.9V, 3V, 3.1V, 3.2V, 3.3V, 3.4V, 3.5V, 3.6V, 3.7V, 3.8V, 3.9V, or 4.0V or so, and the upper limit

thereof may be 5V, 4.9V, 4.8V, 4.7V, 4.6V, 4.5V, 4.4V, 4.3V, 4.2V, 4.1V, 4.0V, 3.9V, 3.8V, 3.7V, 3.6V, 3.5V, 3.4V, 3.3V, 3.2V, 3.1V, 3.0V, 2.9V, 2.8V, 2.7V, 2.6, 2.5V, 2.4V, 2.3V, 2.2V, 2.1V, or 2.0V or so. The oxidation potential Va may be within a range of more than or equal to, or more than any one of the above-described lower limits; or within a range of less than or equal to, or less than any one of the above-described upper limits; or may also have a range between less than or equal to, or less than any one of the above-described upper limits and more than or equal to, or more than any one of the above-described lower limits.

The Vs of Equation 1 above is not particularly limited if it is controlled so that the range of RV is satisfied depending on the oxidation potential of the applied electrode active material or active material layer. For example, the lower limit of the oxidation potential Vs may be 0V, 0.1V, 0.2V, 0.3V, 0.4V, 0.5V, 0.6V, 0.7V, 0.8V, 0.9V, 1.0V, 1.1V, 1.2V, 1.3V, 1.4V, 1.5V, 1.6V, 1.7V, 1.8V, 1.9V, 2.0V, 2.1V, 2.2V, 2.3V, 2.4V, 2.5V, 2.6V, 2.7V, 2.8V, 2.9V, 3V, 3.1V, 3.2V, 3.3V, 3.4V, 3.5V, 3.6V, 3.7V, 3.8V, 3.9V, or 4.0V or so, and the upper limit thereof may also be5V, 4.9V, 4.8V, 4.7V, 4.6V, 4.5V, 4.4V, 4.3V, 4.2V, 4.1V, 4.0V, 3.9V, 3.8V, 3.7V, 3.6V, 3.5V, 3.4V, 3.3V, 3.2V, 3.1V, 3.0V, 2.9V, 2.8V, 2.7V, 2.6V, 2.5V, 2.4V, 2.3V, 2.2V, 2.1V, or 2.0V or so. The oxidation potential Vs may be within a range of more than or equal to, or more than any one of the above-described lower limits; or within a range of less than or equal to, or less than any one of the above-described upper limits; or may also have a range between less than or equal to, or less than any one of the above-described upper limits and more than or equal to, or more than any one of the above-described lower limits.

In the electrode, the upper limit of DC resistance at 25°C of the polymer layer may be10,000 Ω·cm, 9,500 Ω·cm, 9,000 Ω·cm, 8,500 Ω·cm, 8,000 Ω·cm, 7,500 Ω·cm, 7,000 Ω·cm, 6,500 Ω·cm, 6,000 Ω·cm, 5,500 Ω·cm, 5,000 Ω·cm, 4,500 Ω·cm, 4,000 Ω·cm, 3,500 Ω·cm, 3,000 Ω·cm, 2,500 Ω·cm, 2,000 Ω·cm, 1,500 Ω·cm, 1,000 Ω·cm, 950 Ω·cm, 900 Ω·cm, 850 Ω·cm, 800 Ω·cm, 750 Ω·cm, 700 Ω·cm, 650 Ω·cm, 600 Ω·cm, 550 Ω·cm, 500 Ω·cm, 450 Ω·cm, 400 Ω·cm, or 350 Ω·cm or so, and the lower limit thereof may be10 Ω·cm, 50 Ω·cm, 100 Ω·cm, 150 Ω·cm, 200 Ω·cm, 250 Ω·cm, 300 Ω·cm, 350 Ω·cm, 400 Ω·cm, 450 Ω·cm, 500 Ω·cm, 550 Ω·cm, or 600 Ω·cm or so. The DC resistance may be within a range of less than or equal to, or less than any one of the above-described upper limits; or may also have a range between less than or equal to, or less than any one of the above-described upper limits and more than or equal to, or more than any one of the above-described lower limits. The DC resistance is measured in the manner described in "6. DC resistance measurement method" of Examples of this specification.

In the electrode, the upper limit of AC impedance resistance of the polymer layer may be 1,000 Ω, 950 Ω, 900 Ω, 850 Ω, 800 Ω, 750 Ω, 700 Ω, 650 Ω, 600 Ω, 550 Ω, 500 Ω, 450 Ω, 400 Ω, 350 Ω, 300 Ω, 250 Ω, 200 Ω, 150 Ω, 100 Ω, 95 Ω, 90 Ω, 85 Ω, 80 Ω, 75 Ω, 70 Ω, 65 Ω, 60 Ω, 55 Ω, or 50 Ω or so, and the lower limit thereof may be 10 Ω, 15 Ω, 20 Ω, 25 Ω, 30 Ω, 35 Ω, 40 Ω, 450 Ω, 50 Ω, 55 Ω, 60 Ω, 65 Ω, 70 Ω, 75 Ω, 80 Ω, or 85 Ω or so. The AC impedance resistance may be within a range of less than or equal to, or less than any one of the above-described upper limits; or may also have a range between less than or equal to, or less than any one of the above-described upper limits and more than or equal to, or more than any one of the above-described lower limits. The AC impedance resistance is measured in the manner described in "7. Interface resistance (AC impedance resistance)" of Examples of this specification.

As the polymer layer exhibits the DC resistance and/or AC impedance resistance, the electrode, or the secondary battery or electrode assembly to which the electrode is applied may be stably operated or stored in a normal state.

The polymer layermay exhibit a PTC effect designed according to objectives.

For example, the polymer layer may exhibit a characteristic in which ΔR1 of Equation2 below is in a predetermined range.

[Equation 2]

$$\Delta R1 = \mathrm{Max}\{(R_{n+5}/R_n)/5\}$$

In Equation 1, $R_n$ is the DC resistance at any temperature n°C within a range of 25°C to 135°C, and $R_{n+5}$ is the DC resistance at a temperature((n+5)°C) 5°C higher than the temperature n°C,and Max{($R_{n+5}/R_n$)/5} is the maximum value among the ($R_{n+5}/R_n$)/5 values confirmed within the temperature range of 25°C to 135°C.

ΔR1 of Equation 2 is measured for a coin cell to which the polymer layer is applied, and the specific method thereof is described in "8. Measurement of maximum resistance change rate (DC resistance)" of Examples. In the method for confirming the ΔR1, the initial temperature is 25°C and the final temperature is 135°C. The $R_{n+5}$ and $R_n$ are identified by measuring the DC resistance at each temperature while increasing the temperature by 5°C from the initial temperature of 25°C. For example, when n is 90, $R_{95}/R_{90}$ is the ratio of the DC resistance at 95°C to the DC resistance at 90°C. The matter that ΔR1 exhibits100Ω·cm/°C or more at any temperature within the temperature range of 25°C to 135°C means that the resistance increases relatively rapidly at any temperature within the temperature range.

The lower limit of the ΔR1 may be 40, 45, 50, 55, 60, 65, 70, 75, 80, 90, 100, 150, 200, 250, 300, 350, or 400 or so, and the upper limit thereof may be 1,000, 950, 900, 850, 800, 750, 700, 650, 600, 550, 500, 450, 400, 350, 300, 250, 200, or 150 or so. The unit of the ΔR1 is Ω·cm/°C. The ΔR1 may be within a range of more than or equal to, or more than any one of

the above-described lower limits; or may also have a range between less than or equal to, or less than any one of the above-described upper limits and more than or equal to, or more than any one of the above-described lower limits. Through the above characteristics, the electrode can secure stability of a secondary battery or the like in an abnormal state.

The lower limit of the temperature at which the ΔR1 is identified, that is, the temperature at $R_n$, may be 70°C, 80°C, 81°C, 82°C, 83°C, 84°C, 85°C, 86°C, 87°C, 88°C, 89°C, 90°C, 91°C, 92°C, 93°C, 94°C, or 95°C or so, and the upper limit thereof may be 200°C, 190°C, 180°C, 170°C, 160°C, 150°C, 140°C, 130°C, 120°C, 110°C, 100°C, or 90°C or so. The temperature may be within a range of less than or equal to, or less than any one of the above-described upper limits; or within a range of more than or equal to, or more than any one of the above-described lower limits; or may also have a range between less than or equal to, or less than any one of the above-described upper limits and more than or equal to, or more than any one of the above-described lower limits. The temperature is adjusted to a temperature at which an abnormal state occurs or there is a risk that an abnormal state occurs. When a polymer layer exhibiting the characteristics is applied, the electrode, electrode assembly, or secondary battery can secure stability under abnormal conditions while maintaining stable performance even in the case where storage in a normal state is performed at a relatively high temperature and in charging and discharging states at high temperatures.

The polymer may exhibit characteristics in which ΔR2 of Equation 3 below is within a predetermined range.

[Equation 3]

$$\Delta R2 = \mathrm{Max}\{(R_{z+5}/R_z)/5\}$$

In Equation 2, $R_z$ is the AC impedance resistance at any temperature n°C within a range of 25°C to 135°C, and $R_{z+5}$ is the AC impedance resistance at a temperature ((n+5)°C) 5°C higher than the temperature n°C, and Max $\{(R_{z+5}/R_z)/5\}$ is the maximum value among the $(R_{z+5}/R_z)/5$ values confirmed within the temperature range of 25°C to 135°C.

ΔR2 of Equation3 is measured for a coin cell to which the polymer layer is applied, and the specific method thereof is described in "9. Measurement of maximum resistance change rate (AC impedance)" of Examples. In the method for identifying the ΔR2, the initial temperature is 25°C and the final temperature is 135°C. The $R_{z+5}$ and $R_z$are identified by measuring the AC impedance resistance at each temperature while increasing the temperature by 5°C from the initial temperature of 25°C. For example, when n is 90, $R_{95}/R_{90}$ is the ratio of the AC impedance resistance at 95°C to the AC impedance resistance at 90°C. The matter that ΔR2 exhibits 10Ω/°C or more at any temperature within the temperature range of 25°C to 135°C means that the resistance of the polymer layer increases relatively rapidly at any temperature within the temperature range.

The lower limit of the ΔR2 may be 8, 10, 12, 14, 16, 18, 20, 22, 24, 26, 28, 30, 33, 34, 36, 38, 40, 42, or 44 or so, and the upper limit thereof may be 100, 95, 90, 85, 80, 75, 70, 65, 60, 55, 50, 45, 40, 35, 30, 25, 20, 18, or 16 or so. The unit of the ΔR2 is Ω/°C. The ΔR2 may be less than or equal to, or less than any one of the above-described upper limits, ormay be more than or equal to, or more than any one of the above-described lower limits,or may also have a range between less than or equal to, or less than any one of the above-described upper limits and more than or equal to, or more than any one of the above-described lower limits. Through the characteristic, the electrode to which the polymer layer is applied can secure the stability of a secondary battery or the like in an abnormal state.

The lower limit of the temperature at which ΔR2 of the above range is identified, that is, the temperature at $R_z$, may be 80°C, 81°C, 82°C, 83°C, 84°C, 85°C, 86°C, 87°C, 88°C, 89°C, 90°C, 91°C, 92°C, 93°C, 94°C, or 95°C or so, and the upper limit thereof may be 200°C, 190°C, 180°C, 170°C, 160°C, 150°C, 140°C, 130°C, 120°C, 110°C, 100°C, or 90°C or so. The temperature may be within a range of less than or equal to, or less than any one of the above-described upper limits; or within a range of more than or equal to, or more than any one of the above-described lower limits; or may also have a range between less than or equal to, or less than any one of the above-described upper limits and more than or equal to, or more than any one of the above-described lower limits. The temperature is adjusted to a temperature at which an abnormal state occurs or there is a risk that an abnormal state occurs. When a polymer layer exhibiting the characteristics is applied, the electrode, electrode assembly, or secondary battery can secure stability under abnormal conditions while maintaining stable performance even in the case where storage in a normal state is performed at a relatively high temperature and in charging and discharging states at high temperatures.

The conductive polymer forming the polymer layer may be controlled so that the polymer layer exhibits the oxidation potential and PTC effect thus controlled.

The conductive polymer included in the polymer layer may be a polythiophene or a thiophene polymer. In this specification, the term polythiophene or thiophene polymer means a polymer containing thiophene units in a certain level or more. The thiophene unit means a monomer unit formed by polymerizing a thiophene-based monomer, and the thiophene-based monomer means a monomer containing a thiophene skeleton.

The term monomer unit means a structure in which a monomer is polymerized and included in the polymer.

The lower limit of the ratio of the thiophene unit in the polythiophene or thiophene polymer may be about 10 mol%, 15 mol%, 20 mol%, 25 mol%, 30 mol%, 35 mol%, 40 mol%, 45 mol%, 50 mol%, 55 mol%, 60 mol%, 65 mol%, 70 mol%, 75 mol%, 80 mol%, 85 mol%, 90 mol%, or 95 mol% or so, based on the total mole number of all monomer units in the polythiophene or thiophene polymer, and the upper limit thereof may be 99 mol%, 97 mol%, 95 mol%, 93 mol%, 91 mol%, 89 mol%, 87 mol%, 85 mol%, 83 mol%, 81 mol%, 79 mol%, 77 mol%, 75 mol%, 73 mol%, 71 mol%, 69 mol%, 67 mol%, 65 mol%, 63 mol%, 61 mol%, 59 mol%, 57 mol%, 55 mol%, 53 mol%, or 51 mol% or so. The ratio of the thiophene unit may be within a range of more than or equal to, or more than any one of the above-described lower limits; or may also have a range between less than or equal to, or less than any one of the above-described upper limits and more than or equal to, or more than any one of the above-described lower limits.

As the thiophene unit included in the polythiophene, a thiophene unit having a hydrocarbon functional group may be applied.

In this specification, the term hydrocarbon functional group means a monovalent hydrocarbon group (i.e., a monovalent functional group composed of carbon and hydrogen), or a monovalent functional group including the monovalent hydrocarbon group. Therefore, the hydrocarbon functional group may also include other atoms in addition to carbon and hydrogen.An example of the monovalent hydrocarbon group includes an alkyl group, an alkynyl group, or an alkenyl group, and an example of the monovalent functional group including the monovalent hydrocarbon group includes an alkoxy group, an alkylcarbonyl group, or an alkylcarbonyloxy group, but the type of the hydrocarbon functional group is not limited thereto.

The lower limit of the carbon number of the hydrocarbon functional group may be 3, 4, 5, 6, 7, 8, 9, 10, 11, or 12 or so, and the upper limit thereof may also be 20, 19, 18, 17, 16, 15, 14, 13, 12, 11, 10, 9, 8, 7, 6, 5, 4, or 3 or so. The carbon number may be within a range of more than or equal to, or more than any one of the above-described lower limits; or within a range of less than or equal to, or less than any one of the above-described upper limits; or may also have a range between less than or equal to, or less than any one of the above-described upper limits and more than or equal to, or more than any one of the above-described lower limits.

The carbon number may be the total carbon number of the hydrocarbon functional group or the monovalent hydrocarbon group included therein, or the carbon number of the hydrocarbon chain with the longest linear structure included in the hydrocarbon functional group or the monovalent hydrocarbon group included therein. That is, the hydrocarbon functional group or the monovalent hydrocarbon group may have a linear structure or a branched structure, and even in the case of the branched structure, the carbon number constituting the longest linear chain in the branched structure may be within the above range. For example, if the branched structure is a 2-ethylhexyl group, the carbon number constituting the longest chain is 6.

The alkyl group, alkenyl group, alkynyl group, alkoxy group, alkylcarbonyl group, or alkylcarbonyloxy group, which is the hydrocarbon functional group,may also be optionally substituted with one or more substituents.

In the conductive polymer, the lower limit of the molar ratio of the thiophene unit having the hydrocarbon functional group may be 10 mol%, 15 mol%, 20 mol%, 25 mol%, 30 mol%, 35 mol%, 40 mol%, 45 mol%, 50 mol%, 55 mol%, 60 mol%, 65 mol%, 70 mol%, 75 mol%, 80 mol%, or 85 mol% or so, and the upper limit thereof may be 95 mol%, 90 mol%, 85 mol%, 80 mol%, 75 mol%, 70 mol%, 65 mol%, 60 mol%, 55 mol%, 50 mol%, or 45 mol% or so. The ratio is a ratio based on the total mole number of all monomer units included in the polymer. The ratio may be within a range of more than or equal to, or more than any one of the above-described lower limits; or within a range of less than or equal to, or less than any one of the above-described upper limits; or may also have a range between less than or equal to, or less than any one of the above-described upper limits and more than or equal to, or more than any one of the above-described lower limits.

As the conductive polymer comprises the thiophene unit, the polymer or the polymer layer comprising the sameexhibits an appropriate PTC (positive temperature coefficient) effect, and its surface characteristics are adjusted, whereby it is possible to ensure excellent adhesive force in an electrode or a current collector, and it is possible to exhibit an appropriate level of oxidation potential.

The hydrocarbon functional group is a functional group capable of imparting appropriate mobility to the polymerization process of the conductive polymer or the conductive polymer itself. Such a functional group imparts appropriate mobility to a monomer mixture, and diffuses within the monomer mixture to enable polymerization to occur with excellent efficiency. Also, the conductive polymer having the functional group can enable a polymer layer to be formed stably and uniformly between the current collector and the active material layer through appropriate mobility.

The hydrocarbon functional group is appropriately oriented in the drying or annealing process (heat treatment process) applied in the formation process of the polymer layer, whereby it can also impart the suitable PTC effect and oxidation potential characteristics to the polymer.

Upon application of a certain amount of heat energy, the hydrocarbon functional group vibrates due to the heat, and dedoping of anions bound to the polymer are promoted by this vibration (thermal vibration), and accordingly, the resistance increase is induced. The temperature at which the thermal vibration occurs can be controlled by the length and/or amount of the hydrocarbon functional group. For example, under the same temperature, the thermal vibration of a relatively long chain is greater than that of a relatively short chain, whereby the long chain can induce a resistance increase

effect at a relatively low temperature. Therefore, the desired PTC effect can be set through control of the length and/or ratio of the hydrocarbon functional group.

As the thiophene unit of the hydrocarbon functional group, a first thiophene unit having a long-chain hydrocarbon functional group and a second thiophene unit having a short-chain hydrocarbon functional group may be included in the polymer.

The term long-chain hydrocarbon functional group is a hydrocarbon functional group according to the above-described content, but means a hydrocarbon functional group whose carbon number is adjusted to a certain level or more.

The term short-chain hydrocarbon functional group is a hydrocarbon functional group according to the above-described content, but means a hydrocarbon functional group whose carbon number is adjusted to a certain level or less.

The lower limit of the carbon number of the long-chain hydrocarbon functional group may be 10, 11, or 12 or so, and the upper limit thereof may be 20, 19, 18, 17, 16, 15, 14, 13, 12, 11, or 10 or so. The carbon number contained in the long-chain hydrocarbon group may be within a range of more than or equal to, or more than any one of the above-described lower limits; or may also have a range between less than or equal to, or less than any one of the above-described upper limits and more than or equal to, or more than any one of the above-described lower limits.

The lower limit of the carbon number of the short-chain hydrocarbon functional group may be 3, 4, 5, 6, 7, or 8 or so, and the upper limit thereof may also be 9, 8, 7, or 6 or so. The carbon number contained in the short-chain hydrocarbon group may be within a range of less than or equal to, or less than any one of the above-described upper limits; or may also have a range between less than or equal to, or less than any one of the above-described upper limits and more than or equal to, or more than any one of the above-described lower limits.

The specific descriptions of the long-chain and short-chain hydrocarbon functional groups are the same as those described for the hydrocarbon functional group, except for the carbon number.

In the conductive polymer, the lower limit of the ratio of the total mole number of the first and second thiophene units may be 10 mol%, 15 mol%, 20 mol%, 25 mol%, 30 mol%, 35 mol%, 40 mol%, 45 mol%, 50 mol%, 55 mol%, 60 mol%, 65 mol%, 70 mol%, 75 mol%, 80 mol%, or 85 mol% or so, and the upper limit thereof may be 95 mol%, 90 mol%, 85 mol%, 80 mol%, 75 mol%, 70 mol%, 65 mol%, 60 mol%, 55 mol%, 50 mol%, or 45 mol% or so. The ratio is a ratio based on the total mole number of all monomer units included in the polymer. The ratio may be within a range of less than or equal to, or less than any one of the above-described upper limits; or within a range of more than or equal to, or more than any one of the above-described lower limits; or may also have a range between less than or equal to, or less than any one of the above-described upper limits and more than or equal to, or more than any one of the above-described lower limits.

The lower limit of the ratio (M2/M1) of the mole number (M2) of the second thiophene unit to the mole number (M1) of the first thiophene unit in the conductive polymer may be 0.01, 0.05, 0.1, 0.5, 1, 1.5, or 2 or so, and the upper limit thereof may be 100, 95, 90, 85, 80, 75, 70, 65, 60, 55, 50, 45, 40, 35, 30, 25, 20, 15, 10, 9, 8, 7, 6, 5, 4, 3, 2, 1, 0.8, 0.7, 0.6, or 0.55 or so. The ratio may be within a range of less than or equal to, or less than any one of the above-described upper limits; or within a range of more than or equal to, or more than any one of the above-described lower limits; or may also have a range between less than or equal to, or less than any one of the above-described upper limits and more than or equal to, or more than any one of the above-described lower limits.

Under such a ratio, the conductive polymer or the polymer layer exhibits an appropriate PTC (positive temperature coefficient) effect, and its surface characteristics are adjusted, whereby it is possible to ensure excellent adhesive force in an electrode or a current collector.

The polymer may further comprise a thiophene unit having a polar functional group together with the thiophene unit having a hydrocarbon functional group as the thiophene unit.

The term polar functional group is a functional group containing one or two or more polar atoms, for example, oxygen and/or nitrogen. An example of such a functional group includes a carboxyl group, a hydroxy group, an amino group, a cyano group, a nitro group, an ether group, or a functional group of Formula 1 below, but is not limited thereto.

[Formula 1]

$$-L_3-O-\left[L_4-O\right]_n-R_8$$

In Formula 1, $L_3$ is a single bond, an alkylene group, or an alkylidene group, $L_4$ is an alkylene group or an alkylidene group, $R_8$ is hydrogen or an alkyl group, and n is an arbitrary number.

In Formula 1, the matter than $L_3$is a single bond means a form in which $L_3$ does not exist, and the oxygen atom between $L_4$ and $L_3$ is directly connected to the backbone of a monomer or polymer.

In this specification, the term alkylene group means a divalent functional group formed by removing hydrogen atoms from two different carbon atoms, respectively, in an alkane, and the term alkylidene group means a divalent

functional group formed by removing two hydrogen atoms from one carbon atom in an alkane.

In this specification, unless specifically defined otherwise, the term alkylene group may be an alkylene group with 2 to 20 carbon atoms, 2 to 16 carbon atoms, 2 to 12 carbon atoms, 2 to 8 carbon atoms, or 2 to 4 carbon atoms. The alkylene group may be linear or branched or cyclic, which may also be optionally substituted with one or more substituents.

In this specification, unless specifically defined otherwise, the term alkylidene group may be an alkylidene group with 1 to 20 carbon atoms, 1 to 16 carbon atoms, 1 to 12 carbon atoms, 1 to 8 carbon atoms, or 1 to 4 carbon atoms. The alkylidene group may be linear orbranched or cyclic, which may also be optionally substituted with one or more substituents.

In one example, the alkyl group of $R_8$ in Formula 1 may be an alkyl group with 1 to 20 carbon atoms, 1 to 16 carbon atoms, 1 to 12 carbon atoms, 1 to 8 carbon atoms or 1 to 4 carbon atoms, or may be a methyl group or an ethyl group. The alkyl group may be linear, branched, or cyclic, and may be suitably linear or branched.

The lower limit of n in Formula 1 may be 1, 2, 3, or 4 or so, and the upper limit thereof may be 10, 9, 8, 7, 6, 5, 4, or 3 or so. The n may be within a range of less than or equal to, or less than any one of the above-described upper limits; or within a range of more than or equal to, or more than any one of the above-described lower limits; or may also have a range between less than or equal to, or less than any one of the above-described upper limits and more than or equal to, or more than any one of the above-described lower limits.

Through the application of the polar functional group, the polymer layer comprising the conductive polymer may be bonded to other layers to havean appropriate bonding force, and the desired protective function may be efficiently achieved by uniformly forming the conductive polymer layer.

In the case where the thiophene unit having the polar functional group is present in the conductive polymer, the thiophene unit having the polar functional group may be present such that the total mole number of thiophene units having the hydrocarbon functional group is within a predetermined range per mole of the thiophene unit having the polar functional group.

For example, the lower limit of the ratio(i.e., M/M3) of the total mole number (M) of the thiophene unit having the hydrocarbon functional group to the mole number (M3) of the thiophene unit having the polar functional group may be 1, 2, 3, 4, 5, 6, 8 mol, or 8.5 mol or so, and the upper limit thereof may be 500, 450, 400, 350, 300, 250, 200, 150, 100, 95, 90, 85, 80, 75, 70, 65, 60, 55, 50, 45, 40, 35, 30, 25, 20, 15, 10, 9.5 mol, or 9 mol or so. The ratio may be within a range of less than or equal to, or less than any one of the above-described upper limits; or within a range of more than or equal to, or more than any one of the above-described lower limits; or may also have a range between less than or equal to, or less than any one of the above-described upper limits and more than or equal to, or more than any one of the above-described lower limits.

Such a thiophene unit may be, for example, a unit of Formula 2 below.

[Formula 2]

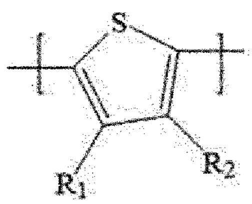

In Formula 2, $R_1$ and $R_2$ may each independently be hydrogen, the polar functional group, or the hydrocarbon functional group.

In another example, $R_1$ and $R_2$ of Formula 1 may also be linked to each other to form a divalent functional group of Formula 3 below.

[Formula 3]

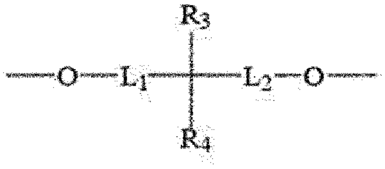

In Formula 3, $L_1$ and $L_2$may each independently be a single bond, an alkylene group, or an alkylidene group, and $R_3$ and $R_4$may each independently be hydrogen, the polar functional group, or the hydrocarbon functional group.

For example, if the unit of Formula 2 is the thiophene unit having the hydrocarbon functional group as described above, one or more of $R_1$ and $R_2$ may be the hydrocarbon functional group (if $R_1$ and $R_2$ are not linked), or one or more of $R_3$ and $R_4$ may be the hydrocarbon functional group (if $R_1$ and $R_2$ are not linked).

For example, if the unit of Formula2 is the thiophene unit having the polar functional group as described above, one or more of $R_1$ and $R_2$ may be the polar functional group (if $R_1$ and $R_2$ are not linked), or one or more of $R_3$ and $R_4$ may be the polar functional group (if $R_1$ and $R_2$ are not linked).

For example, if the unit of Formula 2 above is theabove-described first thiophene unit, one or more of $R_1$ and $R_2$ may be the above-described long-chain hydrocarbon functional group

(if $R_1$ and $R_2$ are not linked), or one or more of $R_3$ and $R_4$ may be the above-described long-chain hydrocarbon functional group (if $R_1$ and $R_2$ are not linked).

For example, if the unit of Formula 2 above is the above-described second thiophene unit, one or more of $R_1$ and $R_2$ may be the above-described short-chain hydrocarbon functional group (if $R_1$ and $R_2$ are not linked), or one or more of $R_3$ and $R_4$ may be the above described short-chain hydrocarbon functional group (if $R_1$ and $R_2$ are not linked).

Specific descriptions of the hydrocarbon functional group, the polar functional group, the long-chain hydrocarbon functional group, and the short-chain hydrocarbon functional group are as described above.

In addition, the specific descriptions of the alkylene group and the alkylidene group of Formula 3 above are as described in Formula 1 above.

The polymer may comprise another additional monomer unit together with the thiophene unit. For example, an additional monomer may be included to adjust the oxidation potential of the polymer. For example, a unit showing a lower oxidation potential or a higher oxidation potential compared to the thiophene unit may be included in the conductive polymer as needed.

The polymer may have a weight average molecular weight (Mw) within a predetermined range. The lower limit of the weight average molecular weight of the polymer may be 10,000 g/mol, 11,000 g/mol, 12,000 g/mol, 13,000 g/mol, 14,000 g/mol, 15,000 g/mol, 16,000 g/mol, 17,000 g/mol, 18,000 g/mol, 19,000 g/mol, 20,000 g/mol, 21,000 g/mol, 22,000 g/mol, 23,000 g/mol, 24,000 g/mol, 25,000 g/mol, 26,000 g/mol, 27,000 g/mol, 28,000 g/mol, 29,000 g/mol, 30,000 g/mol, 31,000 g/mol, 32,000 g/mol, 33,000 g/mol, 34,000 g/mol, 35,000 g/mol, 36,000 g/mol, 37,000 g/mol, 38,000 g/mol, 39,000 g/mol, or 40,000 g/mol or so, and the upper limit thereof may be 2,000,000 g/mol, 1,500,000 g/mol, 1,000,000 g/mol, 900,000 g/mol, 800,000 g/mol, 700,000 g/mol, 600,000 g/mol, 500,000 g/mol, 400,000 g/mol, 300,000 g/mol, 295,000 g/mol, 290,000 g/mol, 285,000 g/mol, 280,000 g/mol, 275,000 g/mol, 270,000 g/mol, 265,000 g/mol, 260,000 g/mol, 255,000 g/mol, 250,000 g/mol, 24 5,000 g/mol, 240,000 g/mol, 235,000 g/mol, 230,000 g/mol, 225,000 g/mol, 220,000 g/mol, 215,000 g/mol, 210,000 g/mol, 205,000 g/mol, 200,000 g/mol, 195,000 g/mol, 190,000 g/mol, 185,000 g/mol, 180,000 g/mol, 175,000 g/mol, 170,000 g/mol, 165,000 g/mol, 160,000 g/mol, 155,000 g/mol, 150,000 g/mol, 145,000 g/mol, 140,000 g/mol, 135,000 g/mol, 130,000 g/mol, 125,000 g/mol, 120,000 g/mol, 115,000 g/mol, 110,000 g/mol, 105,000 g/mol, or 100,000 g/mol or so. The weight average molecular weight may be within a range of less than or equal to, or less than any one of the above-described upper limits; or within a range of more than or equal to, or more than any one of the above-described lower limits; or may also have a range between less than or equal to, or less than any one of the above-described upper limits and more than or equal to, or more than any one of the above-described lower limits.

The molecular weight distribution of the polymer, that is, the ratio of the weight average molecular weight (Mw) to the number average molecular weight (Mn), may be within a predetermined range. The lower limit of the molecular weight distribution may be 2, 2.5, 3, 3.5, or 4 or so, and the upper limit thereof may be 8, 7.5, 7, 6.5, 6, 5.5, 5, 4.5, 4, or 3.5 or so. The molecular weight distribution may be within a range of less than or equal to, or less than any one of the above-described upper limits; or within a range of more than or equal to, or more than any one of the above-described lower limits; or may also have a range between less than or equal to, or less than any one of the above-described upper limits and more than or equal to, or more than any one of the above-described lower limits.

The weight average molecular weight and molecular weight distribution are measured in the manner described in "2. GPC (Gel Permeation Chromatograph)" of Example sections in this specification.

The polymer layer may comprise the polymer. The polymer layer may be composed by comprising only the polymer, or may further comprise any other necessary additives in addition to the polymer. By using the polymer, the desired electrode can be effectively formed. In one example, the lower limit of the amount of the polymer in the polymer layer may be 30 wt%, 35 wt%, 40 wt%, 45 wt%, 50 wt%, 55 wt%, 60 wt%, 65 wt%, 70 wt%, 75 wt%, 80 wt%, 85 wt%, 90 wt%, or 95 wt% or so, and the upper limit thereof may be 100 wt%, 95 wt%, 90 wt%, or 85 wt% or so, based on the total weight of the polymer layer. The ratio is based on the total weight of the polymer layer. The range of the ratio may be within a range of less than or equal to, or less than any one of the above-described upper limits; or within a range of more than or equal to, or more than any one of the above-described lower limits; or may also have a range between less than or equal to, or less than any one of the above-described upper limits and more than or equal to, or more than any one of the above-described lower limits.

The thickness of the polymer layer may be appropriately controlled depending on the objective. For example, the lower limit of the thickness may be 10 nm, 50 nm, 100 nm, 150 nm, 200 nm, 250 nm, 300 nm, 350 nm, 400 nm, 450 nm, or

500 nm or so, and the upper limit thereof may be 2 μm, 1.5 μm, 1 μm, 950 nm, 900 nm, 850 nm, 800 nm, 750 nm, 700 nm, 650 nm, 600 nm, 550 nm, 500 nm, 450 nm, 400 nm, 350 nm, or 300 nm or so. The thickness may be within a range of less than or equal to, or less than any one of the above-described upper limits; or within a range of more than or equal to, or more than any one of the above-described lower limits; or may also have a range between less than or equal to, or less than any one of the above-described upper limits and more than or equal to, or more than any one of the above-described lower limits. The thickness may be measured in the manner described in "3. Thickness measurement" of Example sections in this specification.

The current collector included in the electrode is not particularly limited, and one commonly used as a current collector for the positive electrode or negative electrode can be used.

If the current collector has conductivity without causing chemical changes in applied devices such as secondary batteries, the type, size, and shape thereof, and the like are not particularly limited. An example of a material that can be used as the current collector may be exemplified by a material, and the like in which the surface of copper, aluminum, or stainless steel is surface-treated with carbon, nickel, titanium, or silver, and the like. The current collector may be in the form of a film, sheet, foil, net, porous body, foam, or non-woven fabric, and the like, which comprises the above material. In some cases, a known surface treatment may also be performed on the surface of the current collector to improve adhesive force to other layers such as a polymer layer or an active material layer.

Such a current collector may typically have a thickness within a range of 3μm to 500μm, but is not limited thereto.

A commonly applied layer may also be used as the active material layer.

Typically, the active material layer comprises an electrode active material. The specific type of the electrode active material is not particularly limited, and materials to form a positive electrode or a negative electrode may usually be used.

For example, when the active material layer is a positive electrode active material layer, the electrode active material may include layered compounds such as lithium cobalt oxide ($LiCoO_2$) or lithium nickel oxide ($LiNiO_2$), or compounds substituted with one or more transition metals; lithium iron oxides such as $LiFe_3O_4$; lithium manganese oxides such as Formula $Li_{1+c1}Mn_{2-c1}O_4$ ($0 \leq c1 \leq 0.33$), $LiMnO_3$, $LiMn_2O_3$, or $LiMnO_2$; lithium copper oxides ($Li_2CuO_2$); vanadium oxides such as $LiV_3O_8$, $V_2O_5$, or $Cu_2V_2O_7$; Ni-site lithium nickel oxides represented by Formula $LiNi_{1-c2}M_{c2}O_2$ (where M is at least one selected from the group consisting of Co, Mn, Al, Cu, Fe, Mg, B and Ga, and $0.01 \leq c2 \leq 0.3$ is satisfied); lithium manganese composite oxides represented by Formula $LiMn_{2-c3}M_{c3}O_2$ (where M is at least one selected from the group consisting of Co, Ni, Fe, Cr, Zn, and Ta, and $0.01 \leq c3 \leq 0.1$ is satisfied) or $Li_2Mn_3MO_8$ (here, M is at least one selected from the group consisting of Fe, Co, Ni, Cu and Zn); lithium nickel cobalt manganese (NCM) composite oxides, lithium nickel cobalt manganese aluminum (NCMA) composite oxides, and $LiMn_2O_4$ in which a part of Li in the formula is substituted with alkaline earth metal ions, and the like, but is not limited thereto.

When the active material layer is a negative electrode active material layer, as the electrode active material, for example, a compound capable of reversible intercalation and deintercalation of lithium may be used. A specific example may include carbonaceous materials such as artificial graphite, natural graphite, graphitized carbon fiber, and amorphous carbon; metallic compounds capable of alloying with lithium, such as Si, Al, Sn, Pb, Zn, Bi, In, Mg, Ga, Cd, Si alloy, Sn alloy, or Al alloy; metal oxides capable of doping and de-doping lithium, such as SiOa ($0 < a < 2$), $SnO_2$, vanadium oxide, and lithium vanadium oxide; or a composite comprising the metallic compound and the carbonaceous materials such as a Si-C composite or a Sn-C composite, and the like, and any one or a mixture of two or more of the foregoing may be used.

A metal lithium thin film may also be used as the negative electrode active material, and as the carbon material, low crystalline carbon and high crystalline carbon, and the like may also be used. As the low crystalline carbon, soft carbon and hard carbon are representative, and as the high crystalline carbon, high-temperature baked carbons such as amorphous, plate-like, scale-like, spherical, or fibrous natural graphite or artificial graphite, Kish graphite, pyrolytic carbon, mesophase pitch based carbon fiber, mesocarbon microbeads, mesophase pitches, and petroleum and coal tar pitch derived cokes are representative.

The electrode active material may be included in the active material layer within arange of about 80wt% to 99.5wt%, or within a range of 88 wt% to 99wt%, relative to the total weight of the active material layer, but the ratio may be changed depending on the use or design of the electrode.

The active material layer may further comprise a binder. The binder serves to improve attachment between the active materials, and adhesive force on between the active material layer and the current collector. An example of the binder is not particularly limited, and one or more may be selected from the group consisting of, for example, PVDF (poly(vinylidene fluoride), PVA (poly(vinyl alcohol)), SBR (styrene butadiene rubber), PEO (poly(ethylene oxide)), CMC (carboxyl methyl cellulose), cellulose acetate, cellulose acetate butylate, cellulose acetate propionate, cyanoethylpullulan, cyanoethyl polyvinyl alcohol, cyanoethyl cellulose, cyanoethyl sucrose, pullulan, polymethylmethacrylate, polybutylacrylate, polyacrylonitrile, polyvinylpyrrolidone, polyvinyl acetate, an ethylene vinyl acetate polymer (polyethylene-co-vinyl acetate), and polyarylate, and used.

In one example, the binder may be included in the active material layer within a range of 0.1 parts by weight to 10 parts by weight or 0.5 parts by weight to 5 parts by weight, relative to 100 parts by weight of the electrode active material, but

is not limited thereto.

The active material layer may further comprise a conductive material, as needed. If the conductive material has conductivity without causing chemical changes in the secondary battery, it is not particularly limited, any known material can be used. For example, graphite such as natural graphite or artificial graphite; carbon black, such as carbon black, acetylene black, Ketjen black, channel black, furnace black, lamp black, or thermal black; conductive fibers such as carbon fibers or metal fibers; conductive tubes such as carbon nanotubes (CNTs); metal powders such as fluorocarbon, aluminum, or nickel powder; conductive whiskers such as zinc oxide or potassium titanate; conductive metal oxides such as titanium oxide; conductive materials such as polyphenylene derivatives, and the like may be used.

In one example, the conductive material may be included in the active material layer in an amount of 0.1 parts by weight to 20 parts by weight or 0.3 parts by weight to 10 parts by weight, relative to 100 parts by weight of the electrode active material, but is not limited thereto.

The active material layer may also optionally further comprise any necessary known components in addition to the above-described components.

The present specification also discloses a method for manufacturing the electrode.

The manufacturing method may comprise a step of forming the polymer layer on the current collector, and may comprise a step of forming the active material layer on the polymer layer.

The method of forming the polymer layer on the current collector is not particularly limited. For example, the polymer layer may be formed by a method of diluting the above-described conductive polymer and other additives, if necessary, in an appropriate solvent to prepare a coating liquid, coating the liquid on the current collector, and then drying it.

In another example, the polymer layer may also be formed by directly polymerizing the monomers forming the conductive polymer on the current collector.

The method for preparing a coating composition for forming the polymer layer, and the coating method thereof, and the like are not particularly limited, and a method in a known coating method may be applied. In addition, the method of polymerizing the conductive polymer is not particularly limited, and a known method may be applied. For example, as a method for preparing polythiophene, typically, a method using an oxidation polymerization reaction or a method using a radical reaction is known, and such a method may also be applied to the process of forming the conductive polymer in the present application.

A polymer layer may be formed on a current collector using the prepared coating composition. This process may typically comprise a step of coating the coating composition on a current collector and a step of heat-treating the coated coating composition. In this process, the characteristics of the polymer layer may also be controlled by the conditions of the heat treatment.

For example, the temperature T of the heat treatment and/or the time H of the heat treatment may be controlled.

For example, the lower limit of the temperature T may be 50°C, 55°C, 60°C, 65°C, 70°C, 75°C, 80°C, 85°C, 90°C, 95°C, 100°C, 105°C, 110°C, 115°C, 120°C, 125°C, 130°C, 135°C, or 140°C or so, and the upper limit thereof may be 300°C, 295°C, 290°C, 285°C, 280°C, 275°C, 270°C, 265°C, 260°C, 255°C, 250°C, 245°C, 240°C, 235°C, 230°C, 225°C, 220°C, 215°C, 210°C, 205°C, 200°C, 195°C, 190°C, 185°C, 180°C, 175°C, 170°C, 165°C, 160°C, 155°C, 150°C, 145°C, 140°C, 135°C, 130°C, 125°C, 120°C, 115°C, 110°C, 105°C, 100°C, 95°C, or 90°C or so. The temperature may be within a range of less than or equal to, or less than any one of the above-described upper limits; or within a range of more than or equal to, or more than any one of the above-described lower limits; or within a range between less than or equal to, or less than any one of the above-described upper limits and more than or equal to, or more than any one of the above-described lower limits. Within this range, the alignment state of the hydrocarbon groups in the conductive polymer can be appropriately adjusted, and accordingly, it is possible to secure the desired properties.

To achieve the objective, the product (TXH) of the heat treatment temperature T and the time H may be adjusted. For example, the lower limit of the product (TXH) of the heat treatment temperature T and the time H may be 0.01°C·hour, 0.05°C·hour, 0.1°C·hour, 0.2°C·hour, 0.3°C·hour, 0.5°C·hour, 1°C·hour, 5°C·hour, 10°C·hour, 15°C·hour, 20°C·hour, 25°C·hour, 30°C·hour, 35°C·hour, 40°C·hour, 45°C·hour, 50°C·hour, 75°C·hour, 100°C·hour, 110°C·hour, 120°C·hour, or 130°C·hour or so, and the upper limit thereof may also be 100000°C·hour, 95000°C·hour, 90000°C·hour, 85000°C·hour, 80000°C·hour, 75000°C·hour, 70000°C·hour, 65000°C·hour, 60000°C·hour, 55000°C·hour, 50000°C·hour, 45000°C·hour, 40000°C·hour, 35000°C·hour, 30000°C·hour, 25000°C·hour, 20000°C·hour, 15000°C·hour, 10000°C·hour, 9500°C·hour, 9000°C·hour, 8500°C·hour, 8000°C·hour, 7500°C·hour, 7000°C·hour, 6500°C·hour, 6000°C·hour, 5500°C·hour, 5000°C·hour, 4500°C·hour, 4000°C·hour, 3500°C·hour, 3000°C·hour, 2500°C·hour, 2000°C·hour, 1500°C·hour, 1400°C·hour, 1300°C·hour, 1200°C·hour, 1100°C·hour, 1000°C·hour, 900°C·hour, 800°C·hour, 700°C·hour, 600°C·hour, 500°C·hour, 400°C·hour, 300°C·hour, 200°C·hour, 100°C·hour, 90°C·hour, 80°C·hour, 70°C·hour, 60°C·hour, 50°C·hour, 45°C·hour, 40°C·hour, 35°C·hour, 30°C·hour, 25°C·hour, 20°C·hour, 15°C·hour, 10°C·hour, 5°C·hour, 4°C·hour, 3°C·hour, 2°C·hour, 1°C·hour, or 0.5°C·hour or so. The product (TXH) may be within a range of less than or equal to, or less than any one of the above-described upper limits; or within a range of more than or equal to, or more than any one of the above-described lower limits; or within a range between less

than or equal to, or less than any one of the above-described upper limits and more than or equal to, or more than any one of the above-described lower limits. Within this range, the alignment state of the hydrocarbon groups in the conductive polymer can be appropriately adjusted, and accordingly, it is possible to secure the desired properties.

To more effectively secure the desired properties, the heat treatment may be performed in two steps.

For example, the heat treatment may comprise a step of primarily heat-treating the coating composition at a first temperature T1 for a first time H1 and a step of secondarily heat-treating the coating composition at a second temperature T2 for a second time H2, wherein the temperatures T1 and T2 are different from each other, and/or the times H1 and H2 are different from each other.

For example, the lower limit of the temperature T1 may be 50°C, 55°C, 60°C, 65°C, 70°C, 75°C, 80°C, 85°C, 90°C, 95°C, 100°C, 105°C, 110°C, 115°C, 120°C, 125°C, 130°C, 135°C, or 140°C or so, and the upper limit thereof may be 300°C, 295°C, 290°C, 285°C, 280°C, 275°C, 270°C, 265°C, 260°C, 255°C, 250°C, 245°C, 240°C, 235°C, 230°C, 225°C, 220°C, 215°C, 210°C, 205°C, 200°C, 195°C, 190°C, 185°C, 180°C, 175°C, 170°C, 165°C, 160°C, 155°C, 150°C, 145°C, or 140°C or so. The temperature may be within a range of less than or equal to, or less than any one of the above-described upper limits; or within a range of more than or equal to, or more than any one of the above-described lower limits; or within a range between less than or equal to, or less than any one of the above-described upper limits and more than or equal to, or more than any one of the above-described lower limits. Within this range, the alignment state of the hydrocarbon groups in the conductive polymer can be appropriately adjusted, and accordingly, it is possible to secure the desired properties.

For example, the lower limit of the product(T1XH1) of the temperature T1 and the time H1 of the primary heat treatment may be 0.01°C·hour, 0.05°C·hour, 0.1°C·hour, 0.2°C·hour, or 0.3°C·hour or so, and the upper limit thereof may also be 1000°C·hour, 900°C·hour, 800°C·hour, 700°C·hour, 600°C·hour, 500°C·hour, 400°C·hour, 300°C·hour, 200°C·hour,100°C·hour, 90°C·hour, 80°C·hour, 70°C·hour, 60°C·hour, 50°C·hour, 45°C·hour, 40°C·hour, 35°C·hour, 30°C·hour, 25°C·hour, 20°C·hour, 15°C·hour, 10°C·hour, 5°C·hour, 4°C·hour, 3°C·hour, 2°C·hour, 1°C·hour, or 0.5°C·hour or so. The product (T1XH1) may be within a range of less than or equal to, or less than any one of the above-described upper limits; or within a range of more than or equal to, or more than any one of the above-described lower limits; or within a range between less than or equal to, or less than any one of the above-described upper limits and more than or equal to, or more than any one of the above-described lower limits. Within this range, the alignment state of the hydrocarbon groups in the conductive polymer can be appropriately adjusted, and accordingly, it is possible to secure the desired properties.

For example, for example, the lower limit of the heat treatment temperature T2 of the secondary heat treatment may be 50°C, 55°C, 60°C, 65°C, 70°C, 75°C, 80°C, 85°C, 90°C, 95°C, 100°C, 105°C, 110°C, 115°C, 120°C, 125°C, or 130°C or so, and the upper limit thereof may be 300°C, 295°C, 290°C, 285°C, 280°C, 275°C, 270°C, 265°C, 260°C, 255°C, 250°C, 245°C, 240°C, 235°C, 230°C, 225°C, 220°C, 215°C, 210°C, 205°C, 200°C, 195°C, 190°C, 185°C, 180°C, 175°C, 170°C, 165°C, 160°C, 155°C, 150°C, 145°C, 140°C, 135°C, or 130°C or so. The temperature may be within a range of less than or equal to, or less than any one of the above-described upper limits; or within a range of more than or equal to, or more than any one of the above-described lower limits; or within a range between less than or equal to, or less than any one of the above-described upper limits and more than or equal to, or more than any one of the above-described lower limits. Within this range, the alignment state of the hydrocarbon groups in the conductive polymer can be appropriately adjusted, and accordingly, it is possible to secure the desired properties.

The product (T2XH2) of the secondary heat treatment temperature T2 and the time H2 may be adjusted. For example, the lower limit of the product (T2XH2) of the heat treatment temperature T and the time H may be 10°C·hour, 15°C·hour, 20°C·hour, 25°C·hour, 30°C·hour, 35°C·hour, 40°C·hour, 45°C·hour, 50°C·hour, 75°C·hour, 100°C·hour, 110°C·hour, 120°C·hour, or 130°C·hour or so, and the upper limit thereof may also be 1000°C·hour, 900°C·hour, 800°C·hour, 700°C·hour, 600°C·hour, 500°C·hour, 400°C·hour, 300°C·hour, 200°C·hour,180°C·hour, 160°C·hour, 150°C·hour, 145°C·hour, 140°C·hour, 135°C·hour, or 130°C·hour or so. The product (T2XH2) may be within a range of less than or equal to, or less than any one of the above-described upper limits; or within a range of more than or equal to, or more than any one of the above-described lower limits; or within a range between less than or equal to, or less than any one of the above-described upper limits and more than or equal to, or more than any one of the above-described lower limits. Within this range, the alignment state of the hydrocarbon groups in the conductive polymer can be appropriately adjusted, and accordingly, it is possible to secure the desired properties.

In the above case, the lower limit of the ratio T1/T2 of the temperature T1 of the primary heat treatment and the temperature T2 of the secondary heat treatment may be 0.1, 0.3, 0.5, 0.7, 0.9, 0.95, 1, 1.01, 1.02, 1.03, 1.04, 1.05, 1.06, or 1.07 or so, and the upper limit thereof may be 10, 9, 8, 7, 6, 5, 4, 3, 2, 1.9, 1.8, 1.7, 1.6, 1.5, 1.4, 1.3, 1.2, or 1.1 or so. The ratio T1/T2 may be within a range of less than or equal to, or less than any one of the above-described upper limits; or within a range of more than or equal to, or more than any one of the above-described lower limits; or within a range between less than or equal to, or less than any one of the above-described upper limits and more than or equal to, or more than any one of the above-described lower limits. Within this range, the alignment state of the hydrocarbon groups in the conductive polymer can be appropriately adjusted, and accordingly, it is possible to secure the desired properties.

In the above case, the lower limit of the ratio H2/H1 of the time H1 of the primary heat treatment and the time H2 of

the secondary heat treatment may be 0.5, 1, 3, 5, 7, 9, 10, 11, 12, 13, 14, 14.5, or 15 or so, and the upper limit thereof may be 100, 95, 90, 85, 80, 75, 70, 65, 60, 55, 50, 45, 40, 35, 30, 25, 20, 19, 18, 17, 16, 15.5, or 15 or so. The ratio H2/H1 may be within a range of less than or equal to, or less than any one of the above-described upper limits; or within a range of more than or equal to, or more than any one of the above-described lower limits; or may also have a range between less than or equal to, or less than any one of the above-described upper limits and more than or equal to, or more than any one of the above-described lower limits. Within this range, the alignment state of the hydrocarbon groups in the conductive polymer can be appropriately adjusted, and accordingly, it is possible to secure the desired characteristics.

In the above manufacturing process, a post-process such as an appropriate drying process may also be additionally performed following the coating and/or polymerization process.

Also, the method for forming the active material layer on the polymer layer is not particularly limited. Typically, the active material layer is formed by coating a slurry containing the electrode active material, a binder, and a conductive material on a current collector (on a polymer layer), followed by drying, and then rolling, and this known method can be equally applied to the present application.

The present specification also discloses an electrode assembly or an electrochemical element, for example, a secondary battery, comprising the electrode. If the electrode assembly and the electrochemical element comprises the above-described electrode, specific details of other constitutions are not particularly limited. For example, the electrode assembly may comprise, as is known, a positive electrode, a negative electrode, and a separator between the positive electrode and the negative electrode, where any one of or both the positive electrode and the negative electrode may be the above-described electrode. In addition, the electrochemical element, for example, the secondary battery, may comprise the electrode, or the electrode assembly, and an electrolyte, and the like.

## Advantageous Effects

The present specification discloses an electrode and a use thereof. The electrode comprises a polymer layer showing a PCT (positive temperature coefficient) effect and an oxidation potential, which are controlled according to objectives. Such an electrode cannot affect or can rather improve, in a normal state, performance and operation of a secondary battery by exhibiting excellent electrical properties such as low resistance, and can ensure, in an abnormal state, stability. The present specification also discloses a use of the electrode.

## Description of Drawings

Figure 1 is a cross-sectional diagram of an exemplary electrode.

Figure 2 is an NMR analysis result of a monomer prepared in a preparation example.

Figure 3 is performance evaluation results for the electrode of Example 1.

Figure 4 is performance evaluation results for the electrode of Example 1.

Figure 5 is performance evaluation results for the electrode of Comparative Example 1.

Figure 6 is performance evaluation results for the electrode of Comparative Example 1.

## Mode for Invention

Hereinafter, electrodes and the like disclosed in the present specification are specifically described through examples and comparative examples, but the scope of the electrodes and the like is not limited by the following examples.

### 1. **NMR analysis method**

$^1$H-NMR analyses were performed at room temperature using an NMR spectrometer including a Bruker Ultra Shield spectrometer (300 MHz) with a 5 mm triple resonance probe. A sample was diluted in a solvent ($CDCl_3$) for NMR measurement to a concentration of about 10 mg/ml or so and used, and the chemical shift was expressed in ppm.

**2. GPC (Gel Permeation Chromatograph)**

Molecular weight characteristics were measured using GPC (Gel permeation chromatography). A sample is placed in a 5 mL vial and diluted with chloroform to a concentration of about 1 mg/mL or so. Thereafter, the standard sample for calibration and the sample to be analyzed were filtered through a syringe filter (pore size: 0.45 μm), and then measured. As the analysis program, Waters' Empower 3 was used, and a weight average molecular weight (Mw) and a number average molecular weight (Mn) were each obtained by comparing the elution time of the sample with the calibration curve, and the molecular weight distribution (PDI) was calculated by the ratio (Mw/Mn). The measurement conditions of GPC are as follows.

<GPC measurement conditions>

Device: Waters' 2414

Column: using 3 Styragels from Waters

Solvent: THF (tetrahydrofuran)

Column temperature: 35°C

Sample concentration: 1mg/mL, 1μL injection

Standard sample: polystyrene (Mp: 3900000, 723000, 316500, 52200, 31400, 7200, 3940, 485)

**3. Thickness measurement**

The thickness of the polymer layer, and the like was measured by cross-sectioning an electrode using an ion milling device (Hitachi, IM5000), and then photographing an image with a SEM (Scanning Electron Microscope) (JEOL, JSM-7200F). The conditions for forming the cross section by the ion milling were performed by setting the equipment in cross-section milling mode, the speed (reciprocation/min) of 3, the acceleration voltage of 6.0 kV, the discharge voltage of 15 kV, the current of 150 μA, and the time of 4 hours.

**4. Oxidation potential measurement method (conductive polymer/polymer layer)**

An oxidation potential was measured in the following manner. A layer (hereinafter, polymer layer) with a thickness of about 10 μm was formed on an aluminum foil (Al Foil) with a thickness of about 15 μm using a conductive polymer whose oxidation potential is to be measured. The polymer layer was formed by applying the same method as applied in Example 1 below.

Thereafter, a separator and a lithium film were laminated on the polymer layer to manufacture a laminate in which the aluminum foil/polymer layer/separator/lithium film were laminated, and the laminate was punched into a circle with a diameter of about 1.4 cm or so. A coin cell was manufactured using the circularly punched laminate and an electrolyte (using the Welcos CR2032 coin cell kit).

As the separator, the WL20C model from W Scope Korea was used; as the lithium film, a film with a thickness of about 100 μm or so was used; and as the electrolyte, 1M $LiPF_6$ solution (solvent: EC/DMC/EMC =3/4/3 (mass ratio), EC: Ethylene Carbonate, DMC: dimethyl carbonate, EMC: ethylmethyl carbonate)), which was Enchem's product, was used.

The oxidation potential of the coin cell was measured using an electrochemical meter (potentiostat) (Princeton Applied Research, PARASTAT-MC) at 25°C. The oxidation potential was measured by measuring CV (Cyclic Voltammetry) in the range of 1.5V to 5.5V at a scan rate of 0.17 mV/sec to 0.5 mV/sec. The oxidation potential is the oxidation potential relative to lithium, which is measured based on lithium and lithium ions ($Li/Li^+$).

**5. Oxidation potential measurement method (electrode active material)**

With respect to an oxidation potential of an electrode active material, a coin cell was manufactured through an electrode manufactured using the electrode active material, and it was measured for the relevant coin cell.

A slurry was prepared by formulating an electrode active material to be measured, a conductive material (ECP (Ketjen Black) 0.5%, SFG (Trimrex graphite) 0.4%, DB (Denka Black) 0.4%), PVDF (poly(vinylidene fluoride)), and NMP

(N-Methyl-2-pyrrolidone) in a weight ratio of 75:1:1:23 (electrode active material: conductive material: PVDF: NMP). The slurry was applied onto the current collector with a doctor blade, dried at room temperature (about 25°C), and then maintained in a drying oven at 130°C for 30 minutes or so, and then rolled to form an electrode active material layer with a thickness of about 53μm or so, whereby an electrode was manufactured.

The electrode active material to be measured was used as the electrode active material.

The rolling was performed so that the active material layer had a void ratio of about 25% or so. The void ratio of the active material layer is a value calculated by a method of comparing the ratio of the difference between the actual density and the density after rolling, and the method of obtaining the void ratio in such a manner is known.

An aluminum foil with a thickness of about 15μm or so was used as the current collector.

Thereafter, a separator and a lithium film were laminated on the electrode active material layer of the electrode to manufacture a laminate in which the electrode/separator/lithium film were laminated, and the laminate was punched into a circle with a diameter of about 1.4 cm. A coin cell was manufactured using the circularly punched laminate and an electrolyte (using the Welcos CR2032 coin cell kit).

As the separator, the WL20C model from W Scope Korea was used;as the lithium film, a film with a thickness of about 100 μmor so was used;and as the electrolyte, 1M $LiPF_6$ solution (solvent: EC/DMC/EMC =3/4/3 (mass ratio), EC: Ethylene Carbonate, DMC: dimethyl carbonate, EMC: ethylmethyl carbonate)), which was Enchem's product, was used.

The oxidation potential of the coin cell was measured using an electrochemical meter (potentiostat) (Princeton Applied Research, PARASTAT-MC) at 25°C. The oxidation potential was measured by measuring CV (Cyclic Voltammetry) in the range of 1.5V to 5.5V at a scan rate of 0.17 mV/sec to 0.5 mV/sec.

The oxidation potential is the oxidation potential relative to lithium, which is measured based on lithium and lithium ions ($Li/Li^+$).

### 6. DC resistance measurement method

DC resistance was evaluated using the same coin cell used in the "4. Oxidation potential measurement method (conductive polymer/polymer layer)." However, the thickness of the polymer layer in the coin cell was set to about 200 nm or so. A voltage of 4.3eV was applied to the coin cell for 10 minutes at room temperature (25°C), and the DC resistance was measured using a Fluke digital multi-tester (FLUKE-87-5).

### 7. Interface resistance (AC impedance resistance)

Interface resistance was evaluated through EIS (Electrochemical Impedance Spectronization) using the same coin cell as used in the "4. Oxidation potential measurement method (conductive polymer/polymer layer)." However, the thickness of the polymer layer in the coin cell was set to about 200 nm or so. A voltage of 4.3V was applied to the coin cell for 10 minutes at room temperature (25°C), and the interface resistance obtained in the high frequency region was measured from Nyquist plot obtained by an EIS measurement method at 50,000 Hz to 0.1 Hz. An electrochemical meter (potentiostat) (Princeton Applied Research, PARASTAT-MC) was used as the EIS measurement device.

### 8. Measurement of maximum resistance change rate (DC resistance)

A maximum resistance change rate ΔR1 is determined according to Equation 1 below.

<Equation 1>

$$\Delta R1 = \mathrm{Max}\{(Rn+5/Rn)/5\}$$

The above ΔR1 is measured in the following manner.

A coin cell for DC resistance measurement (coin cell applied in the "6. DC resistance measurement method") is placed in the center of a convection oven (Jeotech, OF3-05W), and the temperature of the oven is set to increase by 5°C per minute from an initial temperature of 25°C to a final temperature of 135°C. The coin cell is connected to a resistance measurement multimeter (Fluke's digital multi-tester (FLUKE-87-5)) outside the oven to enable the resistance measurement. Subsequently, the DC resistance is measured at each temperature in a state where the temperature increases as set. That is, the DC resistance is measured at 25°C, 30°C, 35°C, 40°C, 45°C, 50°C, 55°C, 60°C, 65°C, 70°C, 75°C, 80°C, 85°C, 90°C, 95°C, 100°C, 105°C, 110°C, 115°C, 120°C, 125°C, and 130°C, respectively. Each temperature is maintained for 1 minute according to the set contents, and the DC resistance is measured after 1 minute has elapsed at the relevant temperature. The DC resistance at each temperature becomes Rn of Equation 1 above, and the DC resistance at a temperature that is 5°C higher than the relevant temperature becomes Rn+5 of Equation 1 above. Among the measured

DC resistances, the DC resistances at 25°C, 30°C, 35°C, 40°C, 45°C, 50°C, 55°C, 60°C, 65°C, 70°C, 75°C, 80°C, 85°C, 90°C, 95°C, 100°C, 105°C, 110°C, 115°C, 120°C, and 125°C are each designated as Rn, and 21 values of (Rn+5/Rn)/5 are obtained in the temperature range of 25°C to 130°C, and then the maximum value among them is designated as Max {(Rn+5/Rn)/5}(=ΔR1) of Equation 1 above, and the temperature n°C at (Rn+5/Rn)/5 of the maximum value is designated as the On-Set temperature.

**9. Measurement of maximum resistance change rate (AC impedance)**

A maximum resistance change rate ΔR2 is determined according to Equation 2 below.

<Equation 2>

$$\Delta R2 = \mathrm{Max}\{(Rz+5/Rz)/5\}$$

The ΔR2 is measured in the following manner.

A coin cell for AC impedance resistance measurement (coin cell applied in the "7. Interface resistance (AC impedance resistance)") is placed in the center of a convection oven (Jeotech, OF3-05W), and the temperature of the oven is set to increase by 5°C per minute from an initial temperature of 25°C to a final temperature of 135°C. The coin cell is connected to a resistance measuring device (the measuring device applied in the "7. Interface resistance (AC impedance resistance)") outside the oven to enable the resistance measurement. Subsequently, the AC impedance resistance is measured at each temperature while increasing the temperature as set. That is, AC impedance resistance is measured at 25°C, 30°C, 35°C, 40°C, 45°C, 50°C, 55°C, 60°C, 65°C, 70°C, 75°C, 80°C, 85°C, 90°C, 95°C, 100°C, 105°C, 110°C, 115°C, 120°C, 125°C, and 130°C, respectively. According to the set contents, each temperature is maintained for 1 minute, and the AC impedance resistance is measured at the point when 1 minute has elapsed at the relevant temperature.

The AC impedance resistance at each temperature becomes Rz of Equation 2 above, and the AC impedance resistance at a temperature that is 5°C higher than the relevant temperature becomes Rz+5 of Equation 2 above. Among the measured AC impedance resistances, the AC impedance resistances at 25°C, 30°C, 35°C, 40°C, 45°C, 50°C, 55°C, 60°C, 65°C, 70°C, 75°C, 80°C, 85°C, 90°C, 95°C, 100°C, 105°C, 110°C, 115°C, 120°C, and 125°C are each designated as Rz, and 21 values of (Rz+5/Rz)/5 are obtained in the temperature range of 25°C to 130°C, and the maximum value among them is designated as Max{(Rz+5/Rz)/5}(=ΔR2) of Equation 2 above, and the temperature z°C at (Rz+5/Rz)/5 of the maximum value is designated as the On-Set temperature.

The AC impedance resistance was determined as the resistance obtained from the semicircle of the high frequency region in Nyquist plot obtained by applying a voltage of 4.3V for 10 minutes, andusing EIS measurement at 50,000 Hz to 0.1 Hz.

**Preparation Example 1. Synthesis of monomer (A)**

A monomer of Formula A below was synthesized by the following manner.

[Formula A]

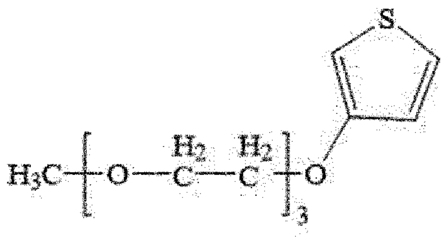

In 100 ml of toluene, 1.372 g (12.02 mmol, 1eq) of 3-methoxythiophene and 3 g (16.83 mmol, 1.4eq) of triethylene glycol monomethyl ether were dissolved together with 230 mg of p-toluenesulfonic acid (p-TsOH), and mixed. While the mixture was refluxed at 120°C to react, methanol generated by the reaction (transetherification) was removed by 4A type molecular sieves filled in an extractor (soxhlet extractor). The reactant was refluxed for 24 hours, and then quenched with water, and extracted with ethyl acetate, and then washed with brine, and dried over magnesium sulfate ($MgSO_4$). The solvent was removed using a rotary evaporator, and the residue was purified by column chromatography eluting with methylene chloride/hexane (2:1) to obtain the target compound (monomer (A)). The NMR analysis results for the target

compound (monomer (A)) are as shown in Figure 2.

**Preparation Example 2. Synthesis of conductive polymer (polythiophene (A))**

To a solution in which 3.20 g (19.71 mmol, 3eq) of iron (III) chloride was dissolved in 150ml of methylene chloride, 1 g (3.94 mmol, 0.6 eq) of 3-dodecylthiophene, 0.33 g (1.97 mmol, 0.3 eq) of 3-hexylthiophene, and 0.16 g (0.66 mmol, 0.1 eq) of the monomer (A) of Preparation Example 1 were introduced, and polymerized at 30°C for 24 hours to prepare a polythiophene (A). In the conductive polymer (A), the molar ratio of the 3-dodecylthiophene unit (I), the 3-hexylthiophene unit (II), and the monomer (A) unit (III) of Preparation Example 1 is 3.94:1.97:0.66 (I:II:III) or so.

The polymerization solution was placed in an osmosis membrane with an MWCO (molecular weight of cut-off) of 5000, and then immersed in 200 ml of an acetonitrile solvent to remove unreacted iron (III) chloride, monomers and low molecular weight oligomers. The residue precipitated inside the osmosis membrane was washed with methanol, and dried at 60°C for 12 hours to obtain polythiophene (A).

The polythiophene (A) had a weight average molecular weight (Mw) and a number average molecular weight (Mn) of 118,000 g/mol and 24,500 g/mol, respectively, and the oxidation potential was about 3.7 V or so.

**Example 1.**

An Al foil with a thickness of about 15 μm or so was used as a current collector. The polythiophene (A) of Preparation Example 2 was dispersed in a solvent (chloroform) at a concentration of 2.0 wt% or so to prepare a coating liquid. The coating liquid was coated on the current collector in a bar coating manner. Subsequently, the current collector on which the coating layer was formed was maintained in a drying oven at 140°C for 4 minutes or so, and again maintained at 130°C or so for 1 hour to form a layer (polymer layer) with a thickness of about 200 nm.

Subsequently, an active material layer was formed on the conductive polymer layer. The active material layer was formed using a slurry. The slurry was prepared by formulating a positive electrode active material, a conductive material (ECP (Ketjen Black) 0.5%, SFG (Trimrex graphite) 0.4%, DB (Denka Black) 0.4%), PVDF (poly(vinylidene fluoride)), and NMP (N-Methyl-2-pyrrolidone) in a weight ratio of 75:1:1:23 (electrode active material: conductive material: PVDF: NMP). The slurry was applied onto the conductive polymer layer with a doctor blade, dried at room temperature, and then maintained in a drying oven at 130°C for 30 minutes or so, and then rolled to form an active material layer with a thickness of about 53 μm (based on electrode active material weight of 0.03 g and void ratio of 18%).

Here, LCO($LiCoO_2$) was used as the electrode active material, and the oxidation potential of the electrode active material measured in the manner described in "5. Oxidation potential measurement method (electrode active material)" was about 3.8V or so.

**Comparative Example 1.**

An electrode was manufactured in the same manner as in Example 1, except that NCM ($Li[N_{0.8}Co_{0.1}Mn_{0.1}]O_2$) was used as the electrode active material when forming the active material layer on the conductive polymer layer. The oxidation potential of the electrode active material measured in the manner described in "5. Oxidation potential measurement method (electrode active material)" for the electrode active material (NCM) was about 3.7V or so.

**Test Example 1. Charge-and-discharge test**

A charge-and-discharge test was performed by manufacturing a coin cell. The coin cell was manufactured using a coin cell kit (Welcos CR2032 coin cell kit) of the CR2032 standard. The electrode manufactured in the example or comparative example was used as a positive electrode, and a lithium film (thickness: about 100 μm) was used as a negative electrode. As an electrolyte, a 1M $LiPF_6$ solution (solvent: EC/DMC/EMC=3/4/3 (mass ratio), EC: ethylene carbonate, DMC: dimethyl carbonate, EMC: ethylmethyl carbonate), which was Enchem's product, was used, and as a separator, a PE (poly(ethylene)) separator (W-Scope Korea, WL20C model) was used.

A charge-and-discharge test was performed using the coin cell, and the test was performed for 6 cycles using the constant current-constant voltage (CC-CV) method in the following order: 0.1C charge/0.1C discharge (cycle 1), 0.2C charge/0.2C discharge (cycle 2), 0.5C charge/0.1C discharge (cycle 3), 0.5C charge/0.5C discharge (cycle 4), 0.5C charge/1C discharge (cycle 5), and 0.5C charge/2C discharge (cycle 6).

Figures 3 and 4 are charge-and-discharge curves performed on the electrode of Example 1, and Figures 5 and 6 are charge-and-discharge curves showing the results of a charge-and-discharge test performed using the electrode of Comparative Example 1.

In Figures 3 and 4, LCO(Ref) means a charge-and-discharge curve in the charge-and-discharge test performed on the electrode manufactured in the same manner as in Example 1, but without forming the conductive polymer layer, and

LCO(SFL) means a charge-and-discharge curve in the charge-and-discharge test performed on the electrode comprising the current collector layer, the conductive polymer layer, and the active material layer, which is manufactured in Example 1.

In Figures 5 and 6, NCM(Ref) means a charge-and-discharge curve in the charge-and-discharge test performed on the electrode manufactured in the same manner as in Comparative Example 1, but without forming the conductive polymer layer, and NCM(SFL) means a charge-and-discharge curve in the charge-and-discharge test performed on the electrode comprising the current collector layer, the conductive polymer layer, and the active material layer, which is manufactured in Comparative Example 1.

From the comparison of the drawings, it can be confirmed that in the case of Example 1, where the oxidation potential of the conductive polymer of the conductive polymer layer (polymer layer) is lower than that of the electrode active material, the efficiency did not decrease even after charge and discharge, but in the case of Comparative Example 1, the efficiency of the coin cell decreases after charge and discharge.

**Test Example 2. PTC effect test**

The results of evaluating the DC resistance, interface resistance, ΔR1, on set temperature to the ΔR1, ΔR2, and on set temperature to the ΔR2 for the electrode of Example 1 among the above-manufactured electrodes are as shown in Table 1 below.

In Table 1 below, Ref. is the results that upon manufacturing the coin cell for evaluating the DC resistance, interface resistance, ΔR1, on set temperature to the ΔR1, ΔR2, and on set temperature to the ΔR2, only the formation conditions of the polymer layer are changed, and other conditions are the same as in Example 1.

That is, in Table 1 below, the results of Example 1 are the results for the coin cell comprising the polymer layer formed by coating the coating liquid prepared by dispersing polythiophene (A) of Preparation Example 2 in the solvent (chloroform) at a concentration of 2.0 wt% or so on the current collector (Al foil) by the bar coating method, maintaining the current collector on which the coating layer is formed in a drying oven at 140°C for 4 minutes or so, and then maintaining it at 130°C or so for 1 hour, and Ref. is the results for the coin cell comprising the polymer layer formed by coating the same coating liquid as above on the same current collector (Al foil) by the bar coating method, and maintaining the current collector on which the coating layer is formed in a drying oven at 90°C for 20 minutes or so.

[Table 1]

| | | Example 1 | Ref. |
|---|---|---|---|
| DC resistance (Ω·cm) | | 420 | 530 |
| Interface resistance (Ω) | | 50 | 60 |
| Equation 1 | ΔR1 | 210 | 55 |
| | On set temperature (°C) | 95 | 85 |
| Equation 2 | ΔR2 | 23.3 | 8.2 |
| | On set temperature (°C) | 95 | 85 |

From Table 1, it can be confirmed that the PTC (Positive Temperature Coefficient) effect designed according to the objective can be obtained through the application of the specific conductive polymer, and that the PTC effect can be additionally controlled depending on the formation method even when the same conductive polymer is applied.

## Claims

**1.** An electrode, comprising:

a current collector;
an active material layer formed on the current collector and comprising an electrode active material; and
a polymer layer comprising a conductive polymer between the current collector and the active material layer,
wherein an oxidation potential of the conductive polymer or the polymer layer is lower than the oxidation potential of the electrode active material or the active material layer.

**2.** The electrode according to claim 1, wherein RV of Equation 1 below is more than 100:

[Equation 1]

$$RV = 100 \times Va/Vs$$

wherein, Va is the oxidation potential of the electrode active material or the active material layer, and Vs is the oxidation potential of the conductive polymer or the polymer layer.

**3.** The electrode according to claim 2, having the oxidation potential Va in a range of 2V to 5V.

**4.** The electrode according to claim 2, having the oxidation potential Vs in a range of 0V to 5V.

**5.** The electrode according to claim 1, wherein the polymer layer has DC resistance of 10,000 Ω cm or less at 25°C.

**6.** The electrode according to claim 1, wherein the polymer layer has AC impedance resistance of 1,000 Ω or less.

**7.** The electrode according to claim 1, wherein ΔR1 of Equation 2 below is 100 Ω·cm/°C or more:

[Equation 2]

$$\Delta R1 = Max\{(R_{n+5}/R_n)/5\}$$

wherein, $R_n$ is the DC resistance of the polymer layer at any temperature n°C within a range of 25°C to 135°C, and $R_{n+5}$ is the DC resistance of the polymer layer at a temperature((n+5)°C) 5°C higher than the temperature n°C, and Max {($R_{n+5}/R_n$)/5} is the maximum value among the ($R_{n+5}/R_n$)/5 values confirmed within the temperature range of 25°C to 135°C.

**8.** The electrode according to claim 7, wherein a temperature at which the ΔR1 of 100 Ω·cm/°C or more is confirmed is 80°C or more.

**9.** The electrode according to claim 1, wherein ΔR2 of Equation 3 below is 10Ω/°C or more:

[Equation 3]

$$\Delta R2 = Max\{(R_{z+5}/R_z)/5\}$$

wherein, $R_z$ is the AC impedance resistance of the polymer layer at any temperature n°C within a range of 25°C to 135°C, and $R_{z+5}$ is the AC impedance resistance of the polymer layer at a temperature ((n+5)°C) 5°C higher than the temperature n°C, and Max{($R_{z+5}/R_z$)/5} is the maximum value among the ($R_{z+5}/R_z$)/5 values confirmed within the temperature range of 25°C to 135°C.

**10.** The electrode according to claim 9, wherein a temperature at which the ΔR2 of 10 Ω/°C or more is confirmed is 80°C or more.

**11.** The electrode according to claim 1, wherein the conductive polymer is a polythiophene comprising a thiophene unit having a hydrocarbon functional group.

**12.** The electrode according to claim 11, wherein the polythiophene comprises, as the thiophene unit, a first thiophene unit having a hydrocarbon functional group with 10 or more carbon atoms and a second thiophene unit having a hydrocarbon functional group with 9 or less carbon atoms.

**13.** The electrode according to claim 11, the polythiophene comprises 30 mol% or more of thiophene units having a hydrocarbon functional group.

**14.** The electrode according to claim 12, wherein a ratio M2/M1 of the mole number M2 of the second thiophene unit to the mole number M1 of the first thiophene unit is in a range of 0.01 to 100.

**15.** The electrode according to claim 11, wherein the polythiophene further comprises a thiophene unit having a polar functional group.

**16.** The electrode according to claim 15, wherein the polythiophene comprises the thiophene unit having a hydrocarbon functional group in an amount of 1 mole to 500 moles per mole of the thiophene unit having a polar functional group.

**17.** An electrode assembly comprising a positive electrode, a negative electrode, and a separator between the positive electrode and the negative electrode,
wherein the positive electrode or the negative electrode is the electrode of any one of claims 1 to 16.

**18.** A secondary battery comprising the electrode assembly of claim 17.

[Figure 1]

| |
|---|
| 300 |
| 200 |
| 100 |

[Figure 2]

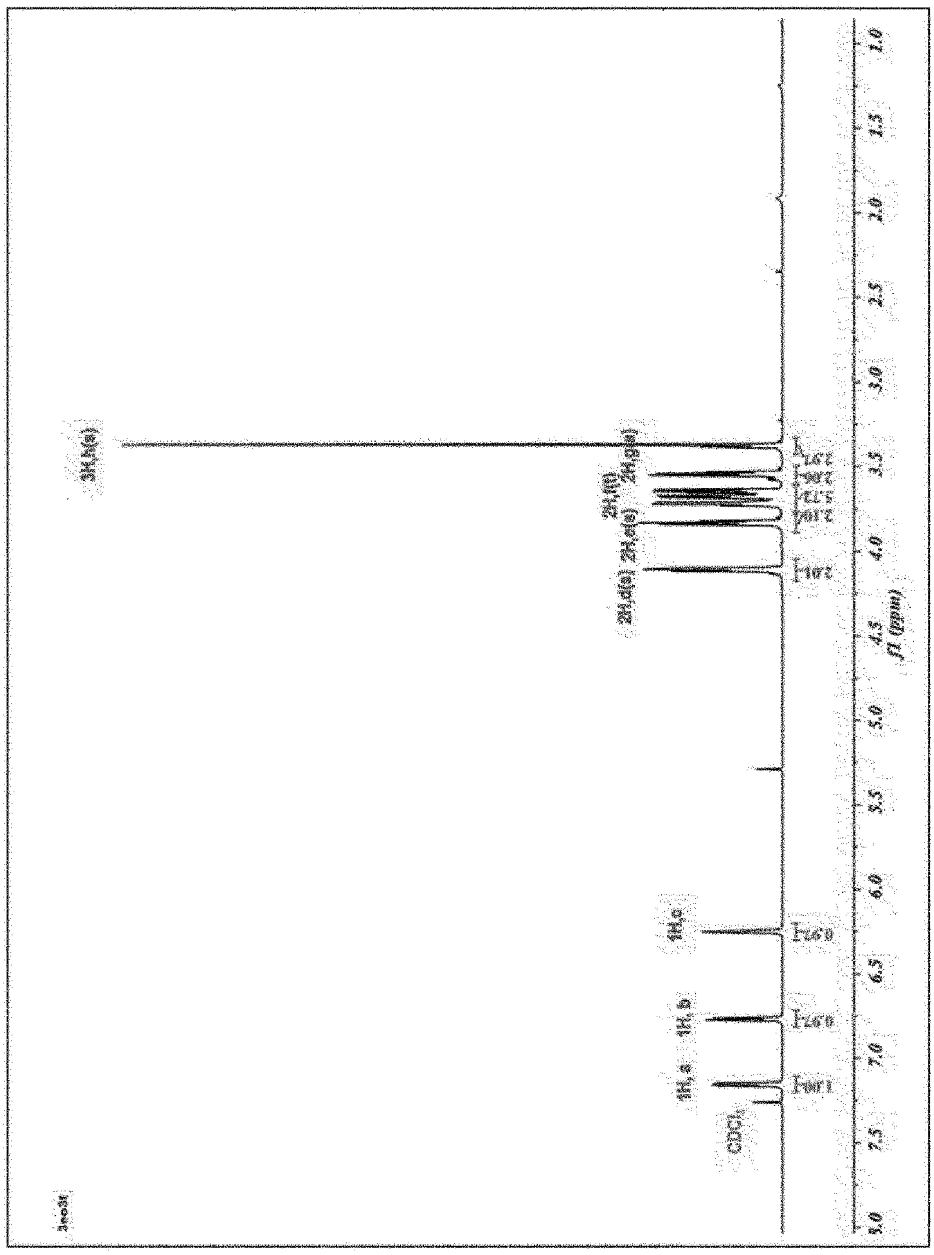

[Figure 3]

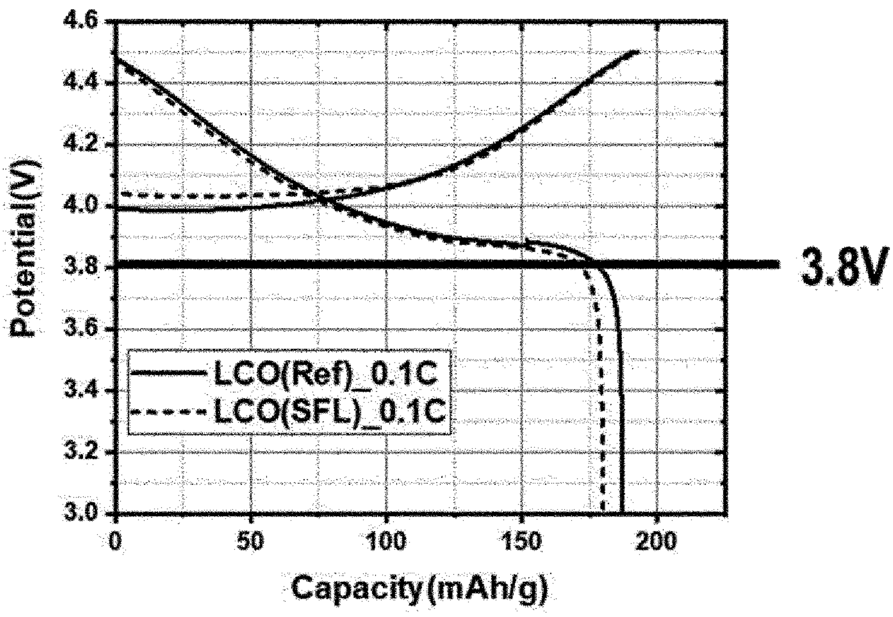


[Figure 4]

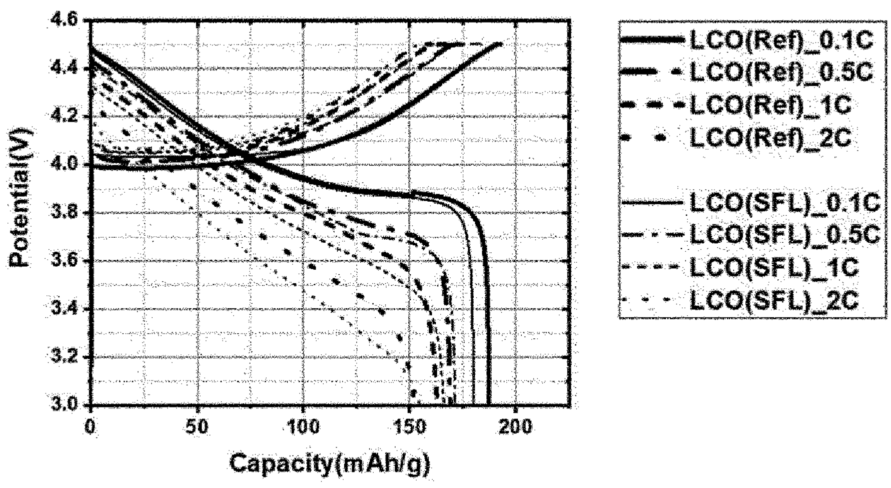

[Figure 5]

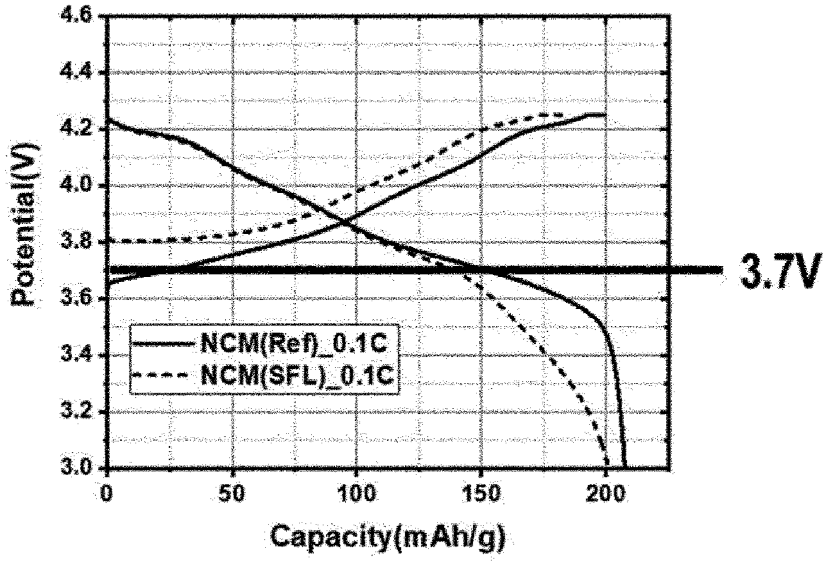


[Figure 6]

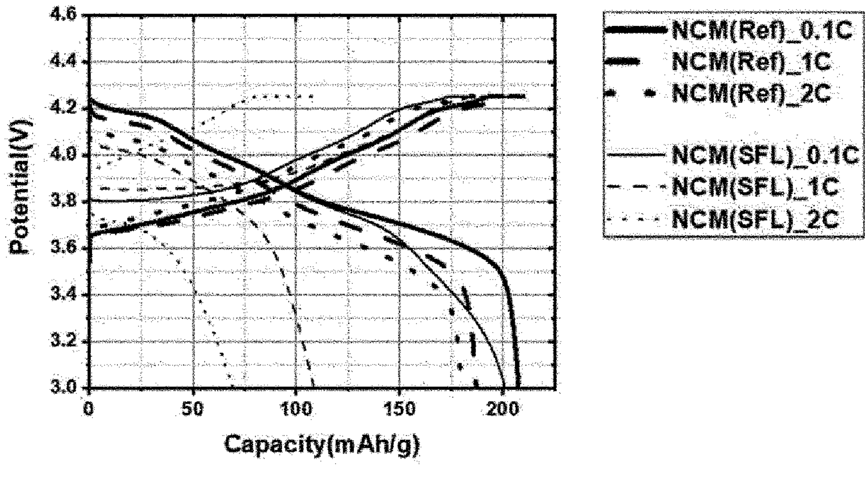

## INTERNATIONAL SEARCH REPORT

International application No.
**PCT/KR2023/016274**

### A. CLASSIFICATION OF SUBJECT MATTER

**H01M 4/131**(2010.01)i; **H01M 4/66**(2006.01)i; **C08G 61/12**(2006.01)i; **C08G 65/326**(2006.01)i; **H01M 10/052**(2010.01)i; **H01M 4/02**(2006.01)i

According to International Patent Classification (IPC) or to both national classification and IPC

### B. FIELDS SEARCHED

Minimum documentation searched (classification system followed by classification symbols)

H01M 4/131(2010.01); H01M 10/052(2010.01); H01M 10/637(2014.01); H01M 2/26(2006.01); H01M 4/13(2010.01); H01M 4/134(2010.01); H01M 4/36(2006.01); H01M 4/66(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 전극조립체(electrode assembly), 전극(electrode), 집전체(current collector), 전극 활물질(electrode active material), 전도성 고분자(conductive polymer), 산화전위(oxidation potential)

### C. DOCUMENTS CONSIDERED TO BE RELEVANT

| Category* | Citation of document, with indication, where appropriate, of the relevant passages | Relevant to claim No. |
|---|---|---|
| X<br>Y | LI, H. et al. Building a Thermal Shutdown Cathode for Li-Ion Batteries Using Temperature-Responsive Poly(3-Dodecylthiophene). Energy Technology. 2020, vol. 8, article no. 2000365, pp. 1-9.<br>See pages 1-4 and 8; and figures 1(a), 1(b), 2(a), 2(d) and 6. | 1-11,13,17-18<br>12,14-16 |
| Y | US 2021-0351413 A1 (GLOBAL GRAPHENE GROUP, INC.) 11 November 2021 (2021-11-11)<br>See claims 1, 5 and 7-14; and paragraphs [0001] and [0092]-[0093]. | 12,14 |
| Y | KR 10-2022-0043773 A (LG ENERGY SOLUTION, LTD.) 05 April 2022 (2022-04-05)<br>See claims 14-18; and paragraphs [0033]-[0037], [0126]-[0127] and [0135]-[0136]. | 15-16 |
| X | US 2019-0140328 A1 (CONTEMPORARY AMPEREX TECHNOLOGY CO., LTD.) 09 May 2019 (2019-05-09)<br>See claims 1 and 3; paragraphs [0018] and [0028]; and figure 1. | 1,17-18 |

☑ Further documents are listed in the continuation of Box C. ☑ See patent family annex.

* Special categories of cited documents:
- "A" document defining the general state of the art which is not considered to be of particular relevance
- "D" document cited by the applicant in the international application
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| **08 February 2024** | **08 February 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

International application No.
**PCT/KR2023/016274**

**C. DOCUMENTS CONSIDERED TO BE RELEVANT**

| Category* | Citation of document, with indication, where appropriate, of the relevant passages | Relevant to claim No. |
|---|---|---|
| A | CN 110676463 A (NINGBO AMTEM NEW ENERGY TECHNOLOGY CO., LTD.) 10 January 2020 (2020-01-10)<br>See entire document. | 1-18 |
| A | KR 10-2015-0035881 A (LG CHEM, LTD.) 07 April 2015 (2015-04-07)<br>See entire document. | 1-18 |

Form PCT/ISA/210 (second sheet) (July 2022)

**INTERNATIONAL SEARCH REPORT**
**Information on patent family members**

International application No.
**PCT/KR2023/016274**

| Patent document cited in search report | Publication date (day/month/year) | Patent family member(s) | Publication date (day/month/year) |
|---|---|---|---|
| US 2021-0351413 A1 | 11 November 2021 | None | |
| KR 10-2022-0043773 A | 05 April 2022 | CN 116420247 A | 11 July 2023 |
| | | EP 4203094 A1 | 28 June 2023 |
| | | US 2023-0335709 A1 | 19 October 2023 |
| | | WO 2022-071704 A1 | 07 April 2022 |
| US 2019-0140328 A1 | 09 May 2019 | CN 109755463 B | 29 December 2020 |
| | | E0 54358 T2 | 28 September 2021 |
| | | EP 3690900 B1 | 21 April 2021 |
| | | ES 2868078 T3 | 21 October 2021 |
| | | PL 3690900 T3 | 06 September 2021 |
| | | US 11289748 B2 | 29 March 2022 |
| CN 110676463 A | 10 January 2020 | CN 110676463 B | 17 August 2021 |
| KR 10-2015-0035881 A | 07 April 2015 | CN 104205426 A | 10 December 2014 |
| | | EP 2816640 A1 | 24 December 2014 |
| | | EP 2816640 A4 | 26 August 2015 |
| | | EP 2816640 B1 | 28 February 2018 |
| | | JP 2015-515722 A | 28 May 2015 |
| | | JP 6169679 B2 | 26 July 2017 |
| | | KR 10-1793270 B1 | 02 November 2017 |
| | | KR 10-2013-0117721 A | 28 October 2013 |
| | | US 2015-0004487 A1 | 01 January 2015 |
| | | US 9786916 B2 | 10 October 2017 |
| | | WO 2013-157863 A1 | 24 October 2013 |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- KR 1020220135150